# EUROPÄISCHE PATENTANMELDUNG

(11) **EP 3 629 683 A1**
(43) Veröffentlichungstag der Anmeldung: **01.04.2020**
(21) Anmeldenummer: 18197030.2
(22) Anmeldetag: 27.09.2018
(51) Int. Cl.: H05K 3/12, B41N 1/24, H05K 3/34

(54) **DRUCKMASKE FÜR DEN RAKELDRUCK, VERFAHREN ZU DEREN HERSTELLUNG UND ANWENDUNG**

(71) Anmelder: Siemens Aktiengesellschaft, 80333 München (DE)
(72) Erfinder: Wormuth, Dirk, 12203 Berlin (DE); Blank, Rene, 12249 Berlin (DE)

(57) **Zusammenfassung**

Die Erfindung betrifft eine Druckmaske (11) mit mindestens einer Öffnung (12), die insbesondere zur Applikation von Lotmaterial oder Sintermaterial (17) auf einen Schaltungsträger (15) geeignet ist. Erfindungsgemäß ist vorgesehen, dass an einem Anfang (20) und an einem Ende (21) (gesehen in Bewegungsrichtung 19 der Rakel 16) eine Fase (22) vorgesehen ist, die ein Einlaufen beziehungsweise Auslaufen des Lotmaterials (17) ermöglicht. Es hat sich überraschenderweise gezeigt, dass hierdurch die Toleranzen eines zu druckenden Lot-Depots oder Sinter-Depots eindeutig verbessert werden können.

## Beschreibung

Die Erfindung betrifft eine Druckmaske für den Rakeldruck, die mindestens eine Öffnung für das zu druckende Material aufweist. Außerdem betrifft die Erfindung ein Verfahren zum Drucken von Material auf eine Unterlage, wobei eine Maske der bezeichneten Art zum Einsatz kommt. Diese Maske wird auf die Unterlage gelegt und das Material mittels einer Rakel auf die Maske aufgebracht. Zuletzt betrifft die Erfindung auch ein Verfahren zum Erzeugen einer solchen Druckmaske.

Die Masken der eingangs angegebenen Art werden nach dem Stand der Technik beispielsweise für die Applikation von Hilfsstoffen wie Lotpaste, Sinterpaste oder andere hoch- beziehungsweise niedrigviskose Stoffe verwendet. Insbesondere beim Bedrucken von Schaltungsträgern wie Leiterplatten finden diese Druckmasken ein weites Anwendungsfeld. Die Druckmasken sind normalerweise als Metallschablonen ausgeführt, wobei die Dicke der Metallschablone (beispielsweise 120pm) und die Größe der Öffnung über das Volumen des zu druckenden Depots an beispielsweise Lotpaste oder Sinterpaste entscheidet.

Bei dem Einsatz von Druckmasken ist es bekannt, dass sich mit diesen nicht Depots absolut gleichmäßiger Dicke erzeugen lassen. Die Dicke der Depots ist vielmehr gewissen Schwankungen innerhalb eines Toleranzbereiches unterworfen. Insbesondere zeigt es sich, dass die Flanken der Depots, die sich jeweils am Rand der Öffnung ausbilden und jeweils parallel oder annähernd parallel zu der Ausrichtung der Rakel befinden (das heißt senkrecht zur Rakelbewegungsrichtung), einen mehr oder weniger steilen Verlauf aufweisen. Mit anderen Worten ist die Materialverteilung insbesondere an diesen Kanten gestört.

Diejenige Kante des Depots die in Bewegungsrichtung der Rakel zuerst erreicht wird weist üblicherweise eine geringere Flankensteilheit auf, da das Material aufgrund seiner Viskosität nicht genügend in die Öffnung eindringt. Hier ist also zu wenig Material vorhanden. Dem gegenüber entsteht an der gegenüberliegenden Kante eine Materialanhäufung, sodass es im Ergebnis nicht zu einem parallelen Verlauf der Oberseite des Depots zur Unterlage sondern zu einem in Rakelrichtung ansteigenden Verlauf kommt. Die Folge ist, dass auf die Depots aufgesetzte Bauelemente schrägstehen, was im weiteren Elektronik-Montageverfahren zu Qualitätsproblemen führen kann.

Durch Variation der Druckparameter (Druckgeschwindigkeit, Rakeldruck, Trenngeschwindigkeit an den Öffnungsrändern) kann die Ausprägung der Toleranzen, wie sich gezeigt hat, nur geringfügig vermindert werden. Daher besteht die Aufgabe der Erfindung darin, eine Druckmaske beziehungsweise ein Verfahren zu deren Verwendung beziehungsweise ein Verfahren zu deren Herstellung anzugeben, wobei die Druckmaske bei ihrer Anwendung die Qualitätsprobleme einer ungleichmäßigen Verteilung des Materials vermindern soll.

Diese Aufgabe wird mit dem eingangs angegebenen Anspruchsgegenstand (Druckmaske) erfindungsgemäß dadurch gelöst, dass die mindestens eine Öffnung an einer Kante der Öffnung zur Oberseite der Maske hin eine Fase aufweist.

Als Oberseite der Maske wird diejenige Seite der Maske gesehen, welche der Rakel mit ihrer Rakelkante zugewandt ist. Mit anderen Worten wird die Unterseite der Druckmaske auf eine Unterlage, ein Substrat, insbesondere einen Schaltungsträger, aufgelegt. Die Öffnungen in Druckmasken werden auch als Apertur bezeichnet. Die Begriffe Öffnung und Apertur werden im Rahmen dieser Erfindungsbeschreibung synonym benutzt.

Durch die Änderung der Apertur-Geometrie dahingehend, dass eine Fase an der Oberseitenkante der Öffnung vorgesehen wird, ist es möglich die obengenannten Effekte überraschend stark zu vermindern. Dabei hat es sich gezeigt, dass die Phase sowohl an der Kante des Materialeintritts als auch an der Kante des Materialaustritts Vorteile für die Verteilung des Materials hinsichtlich der auftretenden Toleranzen bringt. Mit anderen Worten werden die Toleranzen sowohl am Materialeintritt als auch beim Materialaustritt vermindert.

Im Folgenden soll diejenige Kante oder Seite der Öffnung, die durch die Rakelkante zuerst erreicht wird, als Anfang der Öffnung bezeichnet werden und diejenige Kante oder dasjenige Ende der Öffnung, welches zuletzt von der Rakelkante überstrichen wird, als Ende der Öffnung. Hierbei können die Öffnungen unterschiedliche Geometrien aufweisen. Der Anfang und das Ende der Öffnungen ist aber immer durch den Materialeintritt beziehungsweise den Abschluss der Ausfüllung der Öffnung mit dem Material definiert.

Am Beginn der Öffnung führt die Fase dazu, dass das Material langsam in die Öffnung eindringen kann, sodass bei Erreichen des Fasen-Endes die zu überwindende Höhe bis zur Unterlage geringer ist. Daher wird die Flanke, die das auszubildende Depot am Ende haben wird, steiler, mit anderen Worten wird hier mehr Material dosiert. Am Öffnungsende führt die Fase zu einem langsamen Auslaufen der Materialdosierung. Daher wird die Rakelkante nicht wegen eines plötzlichen Querschnittsprungs nach oben gedrückt, sodass es weniger zu einer Überhöhung der Materialdosierung an dieser Öffnungskante kommt. Auch hier bewirkt die Fase daher einen vergleichsmäßigenden Effekt auf die Materialdosierung. Insgesamt verkleinert sich damit vorteilhaft das Toleranzfeld, indem die Höhe des gedruckten Depots liegt.

Beim Abheben der Druckmaske werden Materialreste, die sich im Bereich der Fase angesammelt haben, weitgehend mit abgehoben. Hierdurch entstehen also keine oder nur geringe Materialanhäufungen. Damit sind Druckfehler, die sich aufgrund der Materialanhäufungen in den Fasen ergeben insgesamt geringer als die Druckfehler, die durch die Fasen in der oben beschriebenen Weise verhindert werden.

Gemäß einer Ausgestaltung der Erfindung ist vorgesehen, dass die Fase auf jeweils gegenüberliegenden Kanten der Öffnung angebracht ist.

Die Fase an den gegenüberliegenden Kanten der Öffnung anzubringen, bewirkt, dass sich die positiven Auswirkungen der Fase in der oben beschriebenen Weise sowohl beim Eintritt des Materials in die Öffnung als auch beim vollständigen Ausfüllen der Öffnungen mit dem Material positiv auswirken können. Die gegenüberliegenden Kanten der Öffnungen bestimmen somit auch die Richtung, in der die Rakel über die Druckmaske geführt werden muss, damit die Kanten jeweils am Anfang beziehungsweisen am Ende der Öffnung liegen.

Gemäß einer Ausgestaltung der Erfindung ist vorgesehen, dass die Öffnung quadratisch oder rechteckig ausgeführt ist.

Viele der zu druckenden Depots insbesondere an Sintermaterial oder Lotmaterial in der Elektronikmontage sind quadratisch oder rechteckig. Diese lassen sich vorteilhaft durch entsprechende Öffnungen, die quadratisch oder rechteckig ausgeführt sind, drucken. Selbstverständlich ist es allerdings auch möglich, andere Formen, beispielsweise ovale oder runde Depots zu drücken.

Bei quadratischen oder rechteckigen Depots ist es üblich, dass diese so ausgerichtet sind, dass jeweils zwei Kanten senkrecht und zwei Kanten parallel zur Bewegungsrichtung der Rakel liegen. Damit sind die jeweils gegenüberliegenden Seiten des Rechteckes oder Quadrates, die senkrecht zur Bewegungsrichtung der Rakel liegen, diejenigen, die am Anfang beziehungsweise am Ende der Öffnung liegen und damit mit einer Fase versehen werden müssen. Bei runden oder ovalen Öffnungen muss darauf geachtet werden, dass aufgrund der geplanten Bewegungsrichtung der Rakel ebenfalls ein Anfang und ein Ende der Öffnung entsteht, die allerdings geometrisch nicht so klar definiert sind. Dennoch entsteht ein Eintrittsbereich für das Material sowie ein Bereich, der den Abschluss des Ausfüllens der Öffnung kennzeichnet. Diese beiden Bereiche können mit einer Fase versehen werden, sodass die Dosierung des Materials erleichtert wird.

Gemäß einer Ausgestaltung der Erfindung ist vorgesehen, dass die Fase in einem Winkel zwischen 30° und 60°, insbesondere in einem Winkel von 45°, zur Oberfläche angebracht ist.

Der Winkel der Fase, der zwischen der Oberfläche der Druckmaske und der Fasenfläche gemessen wird, hat Einfluss darauf, wie schnell das Material während der Rakelbewegung in den durch die Fase geschaffenen Raum hineinlaufen (Anfang der Öffnung) beziehungsweise Auslaufen (Ende der Öffnung) kann. Bei einer geringeren Viskosität des Materials kann der Winkel größer gewählt werden, bei einer höheren Viskosität kleiner. Abgesehen hiervon ist es auch möglich, den Winkel bei 45° einzustellen, da dies ein guter Kompromiss für unterschiedliche Viskositäten des Materials ist. Insbesondere die in der Elektronikfertigung verarbeiteten Materialien wie Lotpaste und Sinterpaste lassen sich auf diesem Weg gut dosieren.

Gemäß einer Ausgestaltung der Erfindung ist vorgesehen, dass die Fase eine Höhe aufweist, die mindestens 30 % und höchstens 70 % der Dicke der Maske, insbesondere 50 % der Dicke der Maske ausmacht.

Die Dimensionierung der Fase hat Auswirkungen auf ihren vergleichsmäßigenden Effekt. Es hat sich bei Versuchen gezeigt, dass einerseits die Fase genügend groß sein muss, dass diese das Einlaufen beziehungsweise Auslaufen der Materialdosierung unterstützt, andererseits eine genügend große senkrechte Flanke der Öffnung übrigbleiben muss, damit ein fehlerfreies Abheben der Druckmaske möglich ist. Daher liegt der sinnvolle Bereich der Höhe der Fase im Vergleich zur Dicke der Maske in einem Bereich von einschließlich 30% bis einschließlich 70%. Die Höhe der optimalen Fase hängt nicht zuletzt auch von der Viskosität des zu druckenden Materials ab. Eine Höhe der Fase von 50% der Dicke der Maske hat sich hierbei vorteilhaft als guter Kompromiss herausgestellt.

Die Höhe der Fase wird so gemessen, dass der Unterschied zwischen der Oberfläche der Druckmaske und der durch die Fase in Richtung Unterlage wandernden Kante zwischen Fase und Öffnung gemessen wird.

Die genannte Aufgabe wird alternativ mit dem eingangs angegebenen Anspruchsgegenstand (Verfahren zum Drucken) erfindungsgemäß auch dadurch gelöst, dass eine Druckmaske nach einem der voranstehenden Ansprüche zum Einsatz kommt, wobei die Rakel derart über die Maske geführt wird, dass die Ausrichtung der Fasen parallel zur Rakel liegt.

Bei der Anwendung des Verfahrens zum Drucken von Material muss darauf geachtet werden, dass die Geometrie der Druckmaske durch Vorsehen der Fasen auf den zu druckenden Anwendungsfall angepasst ist. Dies kann durch Versuche ermittelt werden. Dabei kann die Fase der Maske innerhalb der oben angegebenen Parameterbereiche verändert werden. Bei einer optimierten Gestaltung der Geometrie der Öffnungen der Druckmaske wird der Vorteil erreicht, dass die gedruckten Depots gleichmäßiger ausgebildet sind, das heißt deren Geometrie geringeren Toleranzschwankungen unterworfen ist.

Gemäß einer Ausgestaltung der Erfindung ist vorgesehen, dass die Druckmaske eingesetzt wird, um Lotpaste oder Sinterpaste auf einem Schaltungsträger als Unterlage aufzubringen.

Insbesondere bei der Verwendung von Lotpaste oder Sinterpaste lassen sich die Vorteile von enger tolerierten Depots gut nutzen. Auf Sinterpasten-Depots beziehungsweise Lotpasten-Depots werden üblicherweise anschließend Bauelemente aufgesetzt, die vorteilhaft geringere Lagetoleranzen aufweisen, wenn auch die Depots enger toleriert sind. Insbesondere bei Sinterpasten-Depots ist dies von besonderer Wichtigkeit, da die Sinterpasten-Depots ihre Gestalt beim Sintern weniger ändern als die Lotpasten-Depots beim Löten.

Die genannte Aufgabe wird alternativ mit dem eingangs angegebenen Anspruchsgegenstand (Herstellungsverfahren) erfindungsgemäß auch dadurch gelöst, dass
- die Druckmaske mit Öffnungen versehen wird,
- zumindest ein Teil der Kanten der Öffnungen an der Oberseite der Druckmaske mit Fasen versehen wird.

Durch die erfindungsgemäße Reihenfolge bei der Herstellung der Öffnungen in den Druckmasken kann vorteilhaft auf übliche Verfahren bei der Herstellung der Öffnungen in der Druckmaske zurückgegriffen werden. Erst anschließend werden die Kanten der Öffnungen an der Oberseite der Druckmasken mit Fasen versehen, wobei dieser Arbeitsschritt abhängig von einer geometrischen Optimierung in Bezug auf unterschiedliche Materialien erfolgen kann.

Gemäß einer Ausgestaltung der Erfindung ist vorgesehen, dass die Fase durch Schleifen oder Fräsen erzeugt wird.

Beim Schleifen oder Fräsen handelt es sich um spanende Abtragverfahren, die vorteilhaft mit einer genügenden Genauigkeit durchgeführt werden können. Insbesondere metallische Werkstoffe lassen sich auf diese Weise besonders gut bearbeiten. Das Verfahren ist daher auch dazu geeignet, Masken aus Stahl zu modifizieren, wobei es sich bei diesem Werkstoff um einen üblichen Werkstoff für Druckmasken insbesondere in der elektronischen Aufbau- und Montagetechnik handelt.

Gemäß einer Ausgestaltung der Erfindung ist vorgesehen, dass die Fase durch Senkerodieren oder Ätzen erzeugt wird.

Senkerodieren oder Ätzen sind Verfahren, mit denen vorteilhaft auch beispielsweise keramische Werkstoffe für Masken bearbeitet können (gilt für Ätzen). Senkerodieren ermöglicht überdies die Herstellung von hochgenauen Fasen bei metallischen Masken.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Es zeigen:
Figur 1 und 2 eine Druckmaske im Schnitt (Figur 2) und den Höhenverlauf h abhängig vom Ort x in einem Depot (Figur 1), wobei dieses nach dem Stand der Technik hergestellt wurde,
Figur 3 und 4 die erfindungsgemäße Druckmaske geschnitten (Figur 4) und den Höhenverlauf h abhängig vom Ort x eines mit dieser Maske gedruckten Lot-Depots (Figur 3),
Figur 5 ein Ausführungsbeispiel des erfindungsgemäßen Verfahrens,
Figur 6 und 7 mögliche Geometriebereiche für die Maske hinsichtlich unterschiedlicher Fasenwinkel (Figur 6) und Fasenhöhen (Figur 7).

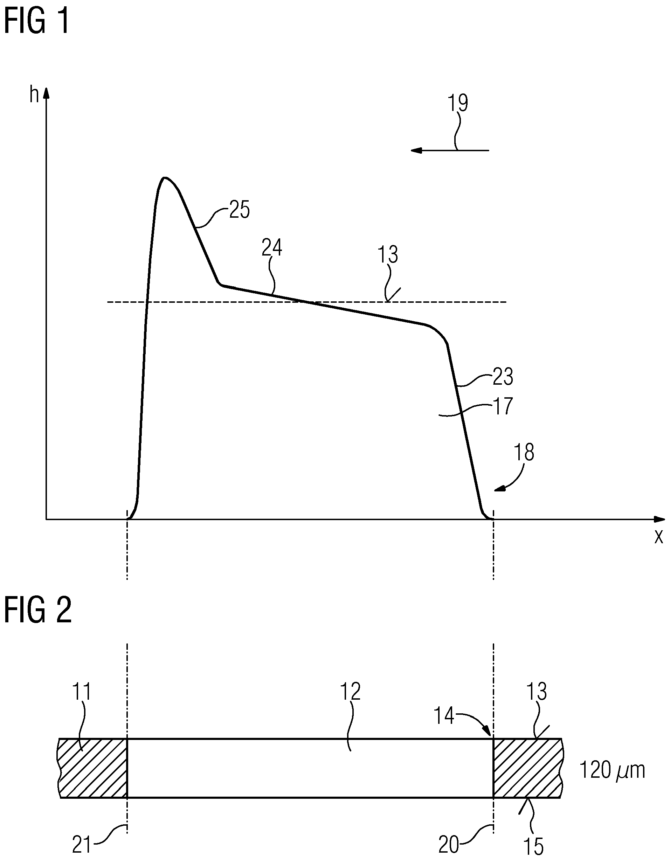

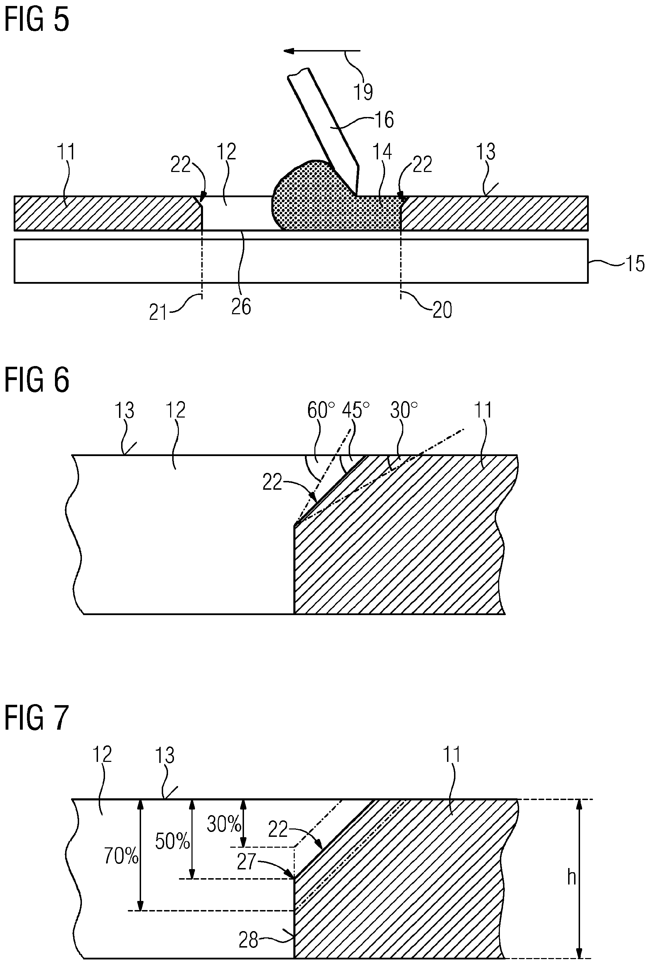

Gemäß Figur 1 und Figur 2 ist eine Druckmaske 11 nach dem Stand der Technik zu erkennen. Diese weist eine Öffnung 12 auf, wobei sich an einer Oberfläche 13 eine Kante 14 der Öffnung 12 ergibt. Mit der Unterseite 15 kann die Druckmaske 11 auf eine nicht dargestellte Unterlage (beispielsweise einen Schaltungsträger 15 gemäß Figur 5) aufgesetzt werden.

Nach Aufsetzen der Druckmaske 11 kann mittels einer Rakel 16 (vergleiche Figur 5) ein Material 17 in die Öffnung 12 eingebracht werden. Der Höhenverlauf h dieses Materials 17 ist in Figur 1 überhöht dargestellt, wobei die Oberseite 13 der Druckmaske 11 in Figur als Strichpunktlinie angedeutet ist. Diese Oberseite definiert eigentlich die Soll-Höhe des Depots 18 an Lotmaterial 17, wobei aus Figur 1 deutlich wird, dass diese Höhe toleranzbehaftet ist. Diese hängt von einer Bewegungsrichtung 19 der Rakel 16 ab.

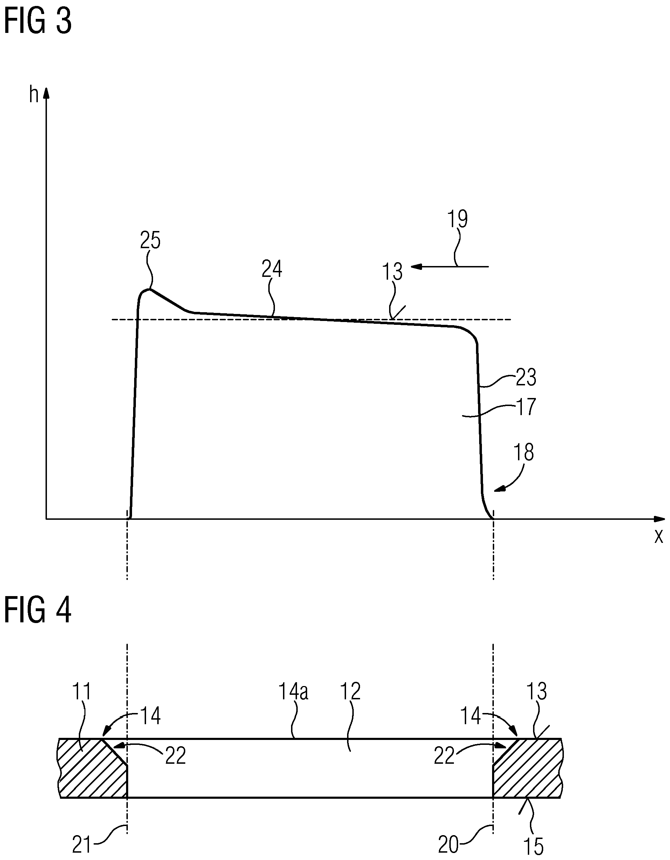

Der Verlauf der Höhe h in Abhängigkeit einer ortsvariablen x soll nun in Bewegungsrichtung 19 von einem Anfang 20 der Öffnung 12 bis zu einem Ende 21 der Öffnung beschrieben werden. Dabei soll ein Vergleich mit einem Höhenverlauf h in Abhängigkeit vom Ort x eines Depots 18 gemäß Figur 3 erfolgen, wobei dieses mit der erfindungsgemäßen Maske 11 gemäß Figur 4 hergestellt wurde. Vorher soll jedoch die Geometrie der erfindungsgemäßen Maske 11 gemäß Figur 4 noch näher erläutert werden.

Diese Maske 11 weist eine Öffnung 12 auf, welche am Anfang 20 und am Ende 21 jeweils eine Fase 22 aufweist. Eine Kante 14a, die parallel zur Bewegungsrichtung 19 liegt, weist keine Fase auf. Mit anderen Worten würde ein Schnitt durch die Öffnung 12 gemäß Figur 4, der senkrecht zur Zeichenebene liegt, so aussehen wie in Figur 2 dargestellt.

Das Depot 18 gemäß Figur 1 weist am Anfang der Öffnung 20 eine weniger steile Flanke 23 auf, als das Depot 18 gemäß Figur 3. Außerdem ist ein Platteau 24 des Depots 18 gemäß Figur 3 eher waagerecht ausgerichtet an der Oberseite 13 der Druckmaske 11 als in Figur 1. Zuletzt weist das Depot 18 gemäß Figur 3 auch eine geringere Überhöhung 25 auf, als Figur 1. Die Überhöhung liegt am Ende 21 der Öffnung 12.

In Figur 5 ist ein Ablauf des erfindungsgemäßen Verfahrens dargestellt. Zu erkennen ist der Schaltungsträger 15 mit einer Kontaktfläche 26 ausgestattet, wobei der Schaltungsträger 15 als Unterlage zum Aufsetzen der Druckschablone 11 dient. Die Öffnung 12 stimmt genau mit der Kontaktfläche 26 überein, sodass auf dieser das Material 17 dosiert werden kann.

Zur Dosierung wird die Rakel 16 über die Oberseite 13 der Druckmaske 11 geführt, sodass die Öffnung 12 mit dem Material 17 ausgefüllt wird. Anschließend wird in nicht dargestellter Weise die Maske 11 von dem Schaltungsträger 15 abgehoben.

In Figur 6 ist dargestellt, dass die Fase 22 unterschiedliche Winkel zur Oberseite 13 einnehmen kann. Der Winkelbereich, der sich als sinnvoll herausgestellt hat, bewegt sich zwischen höchstens 60° und mindestens 30°, bevorzugt 45°. Dabei wird der eine Winkelschenkel jeweils durch die Oberseite 13 und der andere Winkelschenkel durch die Fläche der Fase 22 gebildet.

In Figur 7 ist überdies die Höhe h der erfindungsgemäßen Druckmaske 11 eingezeichnet. Die Höhe kann der erfindungsgemäß verwendeten Druckmasken kann zwischen 50 µm und 500 µm, bevorzugt zwischen 100 µm und 200 µm und noch bevorzugter bei 120 µm liegen.

Außerdem lässt sich Figur 7 entnehmen, dass die Fasenhöhe zwischen mindestens 30% der Höhe h und höchstens 70% der Höhe h der Druckmaske 11 liegen kann. Besonders bevorzugt kann die Höhe bei 50% der Höhe h liegen. Die Höhe der Fase 22 wird gemessen von der Oberseite 13 der Druckmaske 11 bis zu einer unteren Fasenkante 27, die dort liegt, wo die Fase 22 in den senkrechten Bereich 28 der Öffnung übergeht.

### Bezugszeichenliste

- 11: Druckmaske
- 12: Öffnung
- 13: Oberseite
- 14: Kante
- 15: Schaltungsträger
- 16: Rakel
- 17: Material
- 18: Depot
- 19: Bewegungsrichtung
- 20: Anfang
- 21: Ende
- 22: Fase
- 23: Flanke
- 24: Platteau
- 25: Überhöhung
- 26: Kontaktfläche
- 27: Fasenkante
- 28: Bereich

## Patentansprüche

1. Druckmaske (11) für den Rakeldruck (16), mit mindestens einer Öffnung (12) für ein zu druckendes Material 17),
**dadurch gekennzeichnet,**
**dass** die mindestens eine Öffnung (12) an einer Kante (14) der Öffnung (12) zur Oberseite der Maske (11) hin eine Fase (22) aufweist.

2. Druckmaske (11) nach Anspruch 1,
**dadurch gekennzeichnet,**
**dass** die Fase (22) auf jeweils gegenüberliegenden Kanten (14) der Öffnung (12) angebracht ist.

3. Druckmaske (11) nach einem der voranstehenden Ansprüche,
**dadurch gekennzeichnet,**
**dass** die Öffnung (12) quadratisch oder rechteckig ausgeführt ist.

4. Druckmaske (11) nach einem der voranstehenden Ansprüche,
**dadurch gekennzeichnet,**
**dass** die Fase (22) in einem Winkel zwischen 30° und 60°, insbesondere in einem Winkel von 45°, zur Oberfläche angebracht ist.

5. Druckmaske (11) nach einem der voranstehenden Ansprüche,
**dadurch gekennzeichnet,**
**dass** die Fase (22) eine Höhe aufweist, die mindestens 30 % und höchstens 70 % der Dicke der Maske (11), insbesondere 50 % der Dicke der Maske (11) ausmacht.

6. Verfahren zum Drucken von Material (17) auf eine Unterlage, wobei eine Maske (11) zum Einsatz kommt, die auf die Unterlage gelegt wird und das Material (17) mittels einer Rakel (16) auf die Maske (11) aufgebracht wird,
**dadurch gekennzeichnet,**
**dass** eine Druckmaske (11) nach einem der voranstehenden Ansprüche zum Einsatz kommt, wobei die Rakel (16) derart über die Maske (11) geführt wird, dass die Ausrichtung der Fasen (22) parallel zur Rakel (16) liegt.

7. Verfahren nach Anspruch 6,
**dadurch gekennzeichnet,**
**dass** die Druckmaske (11) eingesetzt wird, um Lotpaste oder Sinterpaste auf einem Schaltungsträger als Unterlage aufzubringen.

8. Verfahren zum Erzeugen einer Druckmaske (11) nach einem der Ansprüche 1 bis 5,
**dadurch gekennzeichnet,**
**dass**
• die Druckmaske (11) mit Öffnungen (12) versehen wird,
• zumindest ein Teil der Kanten (14) der Öffnungen (12) an der Oberseite der Druckmaske (11) mit Fasen (22) versehen wird.

9. Verfahren nach Anspruch 8,
**dadurch gekennzeichnet,**
**dass** die Fase (22) durch Schleifen oder Fräsen erzeugt wird.

10. Verfahren nach Anspruch 8,
**dadurch gekennzeichnet,**
**dass** die Fase (22) durch Senkerodieren oder Ätzen erzeugt wird.
